Europäisches Patentamt

European Patent Office

Office européen des brevets

(11) Publication number: **0 456 975 A2**

# EUROPEAN PATENT APPLICATION

(21) Application number: 91102998.1

(51) Int. Cl.5: **H03M 13/00**

(22) Date of filing: **28.02.91**

(30) Priority: **12.05.90 GB 9010723**

(43) Date of publication of application:
**21.11.91 Bulletin 91/47**

(84) Designated Contracting States:
**DE FR GB**

(71) Applicant: **STORNO A/S**
**Artillerivej 126**
**DK-2300 Copenhagen S(DK)**

(72) Inventor: **Jakobsen, Ken**
**Lerso Park Alle**
**DK-2100 Copenhagen(DK)**

(74) Representative: **Dunlop, Hugh Christopher et al**
**Motorola European Intellectual Property Operations Jays Close Viables Industrial Estate**
**Basingstoke, Hampshire RG22 4PD(GB)**

(54) **Reliability test of results from threshold decoder in linear feedback sequence detector.**

(57) This invention relates to a linear feedback sequence detector, such as for detecting ML sequence (maximum length shift register sequence), such as for use in decryption of encrypted data. A method of synchronising to a bit stream is provided, comprising the steps of: receiving a short sequence of bits which form part of a long cyclical sequence of bits; loading the short sequence of bits into a first register (10) having feedback means for counting through the long sequence when clocked; receiving at least one further bit of the long sequence from a predetermined location in the bit stream; performing a first test (14, 20) on the newly received bit to determine whether it is correctly received; performing a second test (20) on the newly received bit to determine whether it can reliably be corrected in view of subsequently received bits; using the resultant bit for updating a second register (18) having feedback means for counting through the long sequence when clocked if either of the first and second tests is successful; but clocking the second register (18) to generate the predicted equivalent of the at least one bit of said long sequence if said bit is determined as incorrectly received and cannot reliably be corrected, whereby the second register maintains its existing synchronisation with the bit stream.

FIG.2

This invention relates to a linear feedback sequence detector, such as for detecting ML sequence (maximum length shift register sequence).

Summary of the Prior Art

A theoretical description of ML sequences and majority threshold detectors is given in W Wesley Peterson and E J Weldon Jnr: 'Error-correcting codes', MIT Press 1972.

In encryption radios, it is necessary to synchronise to a received bit string, so that a decryption algorithm can be performed on data bits in the correct sequence. For this purpose, block synchronization markers are inserted into the bit stream, these markers being bits of an ML sequence.

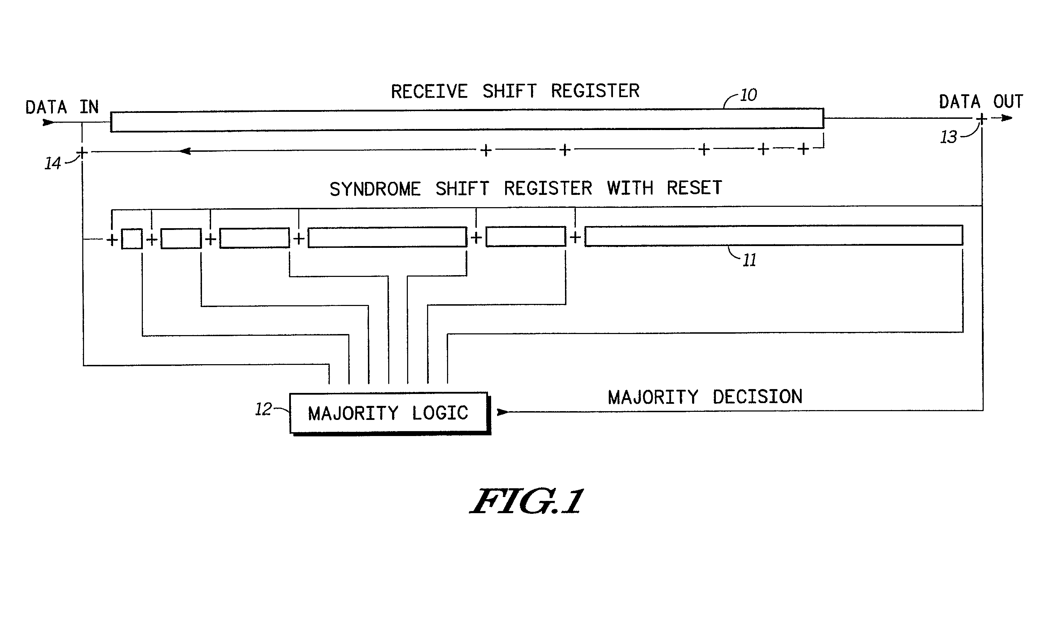

Figure 1a shows a detector for detecting a sequence of this nature. A brief description of Figure 1a will now be given; for a more detailed description, reference is made to European Patent Application No. EP-A-0258702 (Attorney reference CM00321H).

The detector comprises a receive shift register 10 a syndrome shift register 11 (with reset), majority threshold decision logic 12 and an output Exclusive OR gate 13. The receive shift register 10 is shown having six taps, each tap being represented by a 'plus' sign which represents an Exclusive OR gate, comparing the bit at that tap with the bit from the Exclusive OR gate of the previous tap.

The operation of the detector is as follows. Data is inputted to the receive shift register 10. Provided the data is a perfect ML sequence, corresponding to the length of the shift register 10, the data arriving at the Exclusive OR gate 14 from the taps of the register will correspond exactly to the incoming data. Thus, the output from Exclusive OR gate 14 will always be zeros. Provided this is the case, the data is simply passed out of the Exclusive OR gate 13. Of course, in a real environment with background noise, the above perfect case will not always exist. Each time there is a lack of correlation between the next incoming bit and the 'predicted' bit from the received shift register 10, a 'one' is output from Exclusive OR gate 14. This bit is entered into the syndrome shift register and indicates a potential error. If the incoming bit is indeed errored, it will give rise to more errors each time it passes one of the taps in the received shift register 10. Accordingly, more 'ones' will be entered into the syndrome shift register 11. Consider the case where an incoming bit is the only error present, it can be expected that 'one' will be generated at each of the taps of the syndrome shift register 11. The majority threshold logic 12 is triggered above a threshold of five out of seven. In the case of seven 'ones', the threshold is exceeded and the majority threshold logic 12 causes each of the ones in the syndrome shift register to be re-set to 0 and causes the bit emerging from the received shift register 10 to be changed at Exclusive OR gate 13. Thus, the error has been corrected.

The decoder uses the nature of a shift register sequence, which is as follows: Given the size of the shift register n, the feedback circuit and n bits of the past, the next bit can be calculated. This means that if there are no errors, then the following equation is true:

$$\text{bit}(t) = \sum_{i=1}^{N} f_i . \text{bit}(t-i)$$

where

$$\sum_{i=1}^{N} x_i = x_1 \text{ EXOR } x_2 \text{ EXOR } . . . \text{ EXOR } x_{N-1} \text{ EXOR } x_N ,$$

and $f_i$ are the feedback coefficients.

In prior art decoders the output from receive shift register 10 is passed to a temporary buffer. Simultaneously, a closed loop ML shift register containing the immediately preceding ML sequence, is clocked. If the closed loop register and the open loop register agree often enough (at least 44 out of 48 bits) then synchronization is detected and the decryption process is begun. If not enough bits agree, then as soon as the error limit is exceeded, the temporary register contents are parallel loaded in the closed loop register and the synchronization detection process is restarted.

Usually, the best possible estimate of the transmitted signal is the wanted output from such an error correcting decoder, but in case the decoder is decoding an ML sequence, this is not the case. The reason for this is that when receiving an ML sequence, the wanted result is the content of the transmitter shift

2

EP 0 456 975 A2

register. This means that if this content was known as some previous time during receiving, then this knowledge can be used to up-date a local shift register, so only the block synchronization is lost in case of a large block of errors, and resynchronization can therefore be obtained faster. (On the other hand, updating of a local shift register cannot be relied upon too extensively, as it reduces the opportunity for correction of the contents of the local shift register.) Therefore, the result from the decoder is only interesting if the probability of correcting decoding is large.

The purpose of this invention is to check when a majority threshold decoder is decoding correctly.

## Summary of the Invention

According to the present invention, there is provided a method of synchronising to a bit stream, comprising the steps of: receiving a short sequence of bits which form part of a long cyclical sequence of bits; loading the short sequence of bits into a first register having feedback means for counting through the long sequence when clocked; receiving at least one further bit of the long sequence from a predetermined location in the bit stream; performing a first test on the newly received bit to determine whether it is correctly received; performing a second test on the newly received bit to determine whether it can reliably be corrected in view of subsequently received bits; using the resultant bit for updating a second register having feedback means for counting through the long sequence when clocked if either of the first and second tests is successful; but clocking the second register to generate the predicted equivalent of the at least one bit of said long sequence if said bit is determined as incorrectly received and cannot reliably be corrected, whereby the second register maintains its existing synchronisation with the bit stream.

The first test comprises determining whether the at least one received bit is that which is predicted from counting through the long sequence.

The second test may be considered as determining whether the correction of an errored bit introduces an error which is already considered as having been removed.

The second test may alternately be considered as detecting a potentially errored bit, using the potentially errored bit to generate a pre-determined number of further bits of said long sequence, determining whether altering of said potentially errored bit creates more errors than it eliminates, and altering the potentially errored bit if the overall number of errors is so reduced.

## Brief Description of the Drawings

Figure 1 shows a linear feedback sequence detector in accordance with the prior art; and

Figure 2 shows a linear feedback sequence detector in accordance with the preferred embodiment of the invention.

## Detailed Description of a Preferred Embodiment

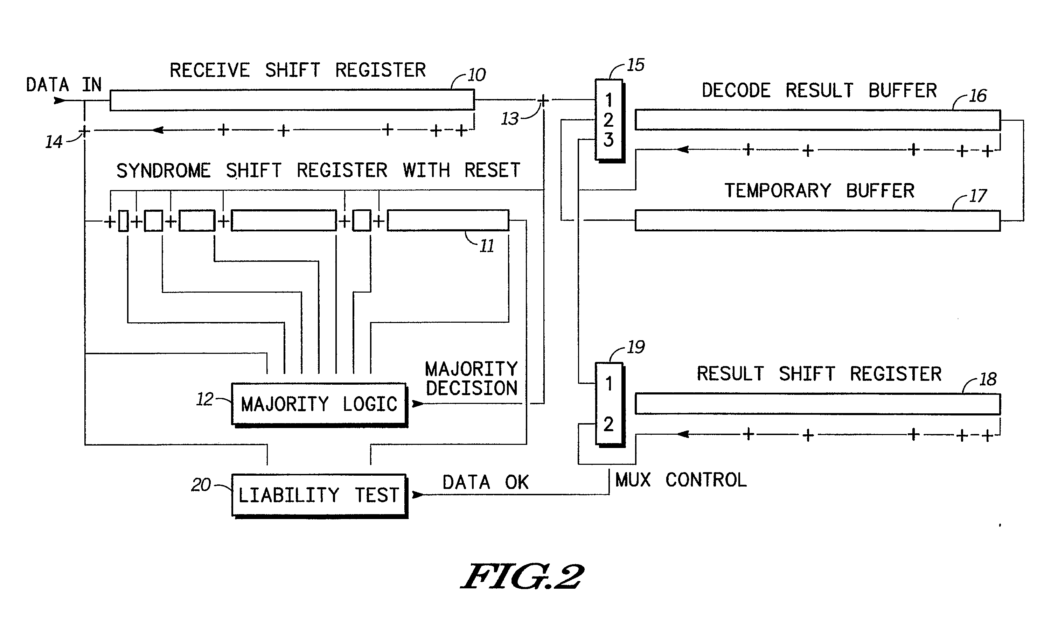

Referring to Figure 2 there is shown a detector having the receive shift register 10, the syndrome shift register 11, the majority threshold logic 12 and the Exclusive OR gates 13 and 14 of Figure 1. The detector also comprises a multi-plexer 15, a decode result buffer 16, a temporary buffer 17, a result shift register 18, a multi-plexer 19 and liability test logic 20.

The case will be considered where the length N of the receive shift register is 42. The length of the full cyclical sequence is $2^{42}$.

The output from the receive shift register 10 (after correction from the majority threshold logic 12) is fed via the multi-plexer 15 to the decode result buffer 16. When the content of the transmitter shift register is wanted, the result in the decode result buffer can be updated to the same content as the transmitter. Updating is necessary because there is a delay of 42 bits in the decoder. In this way, the transmitter can be updated to $2^q$, where $q = 0, 1, 2, \ldots$ times each time a bit is transmitted. This does not change the ML sequence, since $(a + b)^2 = a^2 + b^2$ in GF[2], but it removes the possibility of removing the delay by proper choice of which bit is being transmitted.

The task of the decoder is therefore defined at the received data with no delay. The content of the decode result buffer 16 must, however, not be lost by this updating. For this reason, temporary buffer 17 is needed.

The multi-plexer 15 must here be set in position 1 for 42 clocks, making the update to the transmitter shift register content, and then switched to position 3 for another 42 clocks, re-establishing the content of the result buffer. In this way, the result shift register 18 can collect the output signal by parallel loading from the temporary buffer 17, and by this get the transmitter shift register content.

3

It is the object of the invention to find some way to determine whether the 42 bits in the decode result buffer 16 are reliable or not. If the result is reliable, then the results shift register 18 is completely updated by output from the temporary buffer 17. If not, the result shift register 18 is updated using its feedback circuit (with the multi-plexer 19 being set in position 2). In this way, a large drop out of the decoder will not influence the result, since the sequence can be generated locally.

The test for reliable receipt is as follows.

A first check is made to see if the check sum generated by the decoder provides all zeros, 42 bits in a row. The choice of 42 bits in a row is not determined by theory, but simulations have shown that this is a good choice. This test is performed by the liability test logic 20 from the bits output from the Exclusive OR gate 14. This test, however, demands an error free signal, and the error direction capability of the decoder is therefore not used.

Accordingly a second test is performed. The second test could be arranged by placing an extra syndrome calculating circuit after the decoder, and making a check after the decoder. However it is not necessary to build this extra syndrome calculation circuit, since this second test is equivalent to checking whether all the syndrome bits are reset to zero before they leave the syndrome register. Accordingly, the liability test logic 20 checks the bits emerging from the syndrome register 11 and the second test indicates reliable receipt if all the syndrome bits are reset to zero 31 bits in a row before they leave the syndrome register. This cannot value of 31 bits could be reduced, but falsing increases at lower values and count of about 25 is considered to be the minimum workable count value.

The two tests have been shown to be able to make a safe detection of when the last 42 decoded bits are correct, and the test after the decoder is more reliable than the test before the decoder in higher bit error rates. However, the syndrome bits are valid after receiving 42 bits, where as the syndrome register output is valid after 84 bits. This means that at low bit error rates test 1 will be successful before test 2, but, as mentioned, in high bit error rates, test 1 will probably never be successful.

For optimum reliability, both tests are applied at the same time. The data input to the decode result buffer 16 is therefore accepted as reliable if test 1 or test 2 is successful.

If, with each newly received bit, one or other test is successful, the contents of the temporary buffer 17 are parallel loaded in the result shift register 18. With this, the last 42 received bits can be read in the result shift register without any delay.

The invention provides a more reliable test than test 2 alone, because there may be occasions where a re-set operation is performed on the syndrome shift register, which causes the reversal of a bit due to a majority decision in the majority threshold logic 12, where that bit had previously passed the first test, and should therefore probably not have been re-set.

If both tests fail, the temporary buffer 17 is not parallel loaded into the result shift register, but instead the result shift register is clocked to generate the next bit of the full sequence based on the existing position in the sequence. Both counters are reset to zero and the result shift register is clocked continuously until a further 31 bits are received in sequence with either test 1 or test 2 succeeding for the new bits, during this period, the majority threshold logic continues to correct received bits and reset 'ones' in the syndrome register.

## Claims

1. A method of synchronising to a bit stream, comprising the steps of:

   receiving a short sequence of bits which form part of a long cyclical sequence of bits;

   loading the short sequence of bits into a first register having feedback means for counting through the long sequence when clocked;

   receiving at least one further bit of the long sequence from a predetermined location in the bit stream;

   performing a first test on the newly received bit to determine whether it is correctly received;

   performing a second test on the newly received bit to determine whether it can reliably be corrected in view of subsequently received bits;

   using the resultant bit for updating a second register having feedback means for counting through the long sequence when clocked if either of the first and second tests is successful; but

   clocking the second register to generate the predicted equivalent of the at least one bit of said long sequence if said bit is determined as incorrectly received and cannot reliably be corrected, whereby the second register maintains its existing synchronisation with the bit stream.

2. A method according to claim 1, wherein the error check operation comprises determining whether the at least one received bit is that which is predicted from counting through the long sequence.

3. A method according to any one of the previous claims comprising the further steps of:
determining whether the correction of an errored bit introduces an error that is already considered as having been removed;
maintaining the existing synchronisataion if such is the case; and
making no further updating of the register nor corrections of errors until a complete new short sequence of bits forming part of the long sequence is received.

4. A method according to claim 1, wherein the error check operation comprises:
detecting a potentially errored bit,
using the potentially errored bit to generate a predetermined number of further bits of said long sequence,
determining whether altering of said potentially errored bit creates more errors than it eliminates,
altering said potentially errored bit if the overall number of errors is so reduced.

5. A method according to claim 4, comprising the steps of:
clocking the at least one received bit through the first register;
performing a majority threshold decision on a plurality of taps in the first register at which an errored received bit would be expected to generate further errors; and
from said decision, determining whether errors are generated as expected.

6. A method according to claim1, wherein the first test comprises checking whether the bits generated by the register are equal to the bits received for approximately N bits in a row where N is the length of the register.

7. A method according to claim 1, wherein the second test comprises checking that newly received bits can reliably be corrected at least 25 bits in a row.

*FIG.1*

*FIG.2*